# EUROPÄISCHE PATENTANMELDUNG

(11) **EP 2 079 115 A2**
(43) Veröffentlichungstag der Anmeldung: **15.07.2009**
(21) Anmeldenummer: 09100010.9
(22) Anmeldetag: 05.01.2009
(51) Int. Cl.: H01L 41/053, H01L 41/083, F02M 51/06

(54) **Piezoelektrisches Aktormodul und Brennstoffeinspritzventil**

(30) Priorität: 10.01.2008 DE 102008003841
(71) Anmelder: Robert Bosch GmbH, 70442 Stuttgart (DE)
(72) Erfinder: Herwig, Roland, 74354, Besigheim (DE); Schaich, Udo, 70378, Stuttgart (DE)

(57) **Zusammenfassung**

Ein piezoelektrisches Aktormodul (2) für ein Brennstoffeinspritzventil (1) weist einen Aktorkörper (23) auf, der eine Vielzahl von keramischen Schichten (26, 27) und eine Vielzahl von zwischen den keramischen Schichten (26, 27) angeordneten Elektrodenschichten (28, 29) aufweist. Dabei sind an den Aktorkörper (23) ein Aktorfuß (24) und ein Aktorkopf (25) angefügt. Der Aktorkörper (23) ist von einem Aktorschlauch (37) umgeben, der mit dem Aktorfuß (24) und dem Aktorkopf (25) verbunden ist. Zwischen dem Aktorkörper (23) und dem Aktorschlauch (37) ist ein Zwischenraum (40) ausgebildet, der mit einem Füllmittel (41) aufgefüllt ist. Der Aktorschlauch (37) ist aus einer gewickelten metallischen Schicht (43) und einer gewickelten polymeren Schicht (42) aufgebaut, die miteinander verbunden sind. Im Ergebnis ist eine zuverlässige Abdichtung des Aktorkörpers (23) gegenüber dem im Aktorraum (5) vorgesehenen Brennstoff gewährleistet.

## Beschreibung

### Stand der Technik

Die Erfindung betrifft ein piezoelektrisches Aktormodul für ein Brennstoffeinspritzventil und ein Brennstoffeinspritzventil mit solch einem piezoelektrischen Aktormodul. Speziell betrifft die Erfindung das Gebiet der Injektoren für Brennstoffeinspritzanlagen von luftverdichtenden, selbstzündenden Brennkraftmaschinen.

Aus der DE 101 33 151 A1 ist ein Bauteil mit einem Bauelement und einem das Bauelement umgebenden Gehäuse bekannt. Dabei ist zwischen dem Gehäuse und dem Bauelement ein geringer Abstand vorgesehen, der eine Gießspalte definiert. In die Gießspalte ist eine Vergussmasse eingefüllt, die einen vernetzenden Füllstoff enthält. Dabei ist ein relativ hoher Füllstoffgehalt der Vergussmasse vorgegeben, wobei der Füllstoffgehalt bezogen auf das Gesamtgewicht der Vergussmasse zwischen 20 und 90 Gewichtsprozent liegt. Als Vergussmasse können Harze auf der Basis von Siliconen, Polyurethanen und Epoxiden eingesetzt werden, die mit einem Füllstoff aus der Gruppe Siliziumdioxid, Aluminiumoxid, Titandioxid, Bornitrid und Aluminiumnitrid gefüllt sind, um ihre Wärmeleitfähigkeit zu verbessern.

Das aus der DE 101 33 151 A1 bekannte Bauteil hat den Nachteil, dass die Herstellung aufwändig ist. Speziell ist die Vorgabe einer schmalen, gleichmäßigen Gießspalte und deren homogene Befüllung relativ aufwändig. Ferner besteht bei einem solchen Bauteil, bei dem das Bauelement aus einem Piezoaktor gebildet ist, das Problem, dass die Vergussmasse sowohl in Verbindung mit dem Bauelement als auch mit dem Gehäuse steht, so dass im Betrieb bei periodischen Dehnungen des Bauelements Spannungen in der Vergussmasse auftreten, was sich ungünstig auf die Zuverlässigkeit und Funktionsfähigkeit auswirken kann.

### Offenbarung der Erfindung

Das erfindungsgemäße Aktormodul mit den Merkmalen des Anspruchs 1 und das erfindungsgemäße Brennstoffeinspritzventil mit den Merkmalen des Anspruchs 10 haben den Vorteil, dass eine relativ kostengünstige Herstellung ermöglicht ist, wobei ein zuverlässiger Schutz gegenüber Medien gewährleistet ist, und dass insbesondere eine hohe Zuverlässigkeit und Funktionsfähigkeit gewährleistet ist.

Durch die in den Unteransprüchen aufgeführten Maßnahmen sind vorteilhafte Weiterbildungen des im Anspruch 1 angegebenen Aktormoduls und des im Anspruch 10 angegebenen Brennstoffeinspritzventils möglich.

In vorteilhafter Weise kann das piezoelektrische Aktormodul in einem Aktorraum eines Brennstoffeinspritzventils angeordnet sein, wobei sich im Aktorraum unter hohem Druck stehender Brennstoff befindet. Bei dieser Anordnung besteht die Gefahr, dass der Brennstoff oder ein Bestandteil des Brennstoffs zu dem Aktorkörper oder anderen Bauteilen des piezoelektrischen Aktors vordringt, wodurch die Funktionsfähigkeit des Brennstoffeinspritzventils beeinträchtigt werden kann. Beispielsweise kann Wasser, das im Dieselbrennstoff enthalten ist, einen Kurzschluss zwischen den Elektrodenschichten des Aktorkörpers bedingen, wodurch das piezoelektrische Aktormodul ausfällt. Außerdem kann es durch chemische oder physikalische Einwirkung zur Beschädigung des Aktorkörpers oder anderer Elemente des piezoelektrischen Aktormoduls kommen. Der Aktorschlauch, der den Aktorkörper umgibt und zumindest eine gewickelte metallische Schicht und zumindest eine gewickelte polymere Schicht aufweist, dichtet den Aktorkörper zuverlässig gegenüber der Umgebung ab. Durch die mehrschichtige Ausgestaltung des Aktorschlauches, die aus zwei oder mehr Schichten gegeben ist, kann dabei im Hinblick auf das einwirkende Medium, insbesondere Brennstoff, eine optimierte Dichtwirkung erzielt werden. Dadurch werden auch kleine Wandstärken, beispielsweise im Bereich von ca. 30 µm ermöglicht.

Durch den Aktorschlauch kann somit eine kostengünstige und montagefreundliche Lösung aus zumindest einem Kunststoff und zumindest einem Metall erreicht werden. Die metallische Schicht des Aktorschlauches kann dabei aus einem Metall oder einer Metalllegierung gebildet sein. Außerdem kann ein prozesssicheres Anliefersystem für den Arbeitsgang der Montage des piezoelektrischen Aktormoduls erstellt werden, so dass nicht prozesssichere Wickelprozesse vermieden sind.

Ferner kann der Vorteil erzielt werden, dass eine dünnwandige Schutzhülse im Mikrometerbereich in Form des Aktorschlauches besteht, so dass der Durchfluss des Brennstoffes erhöht und/oder eine engere Gestaltung des Aktorraumes und somit des Außendurchmessers des Brennstoffeinspritzventils möglich ist. Speziell kann durch ein größeres, im Aktorraum verbleibendes Volumen nach dem Einbau des piezoelektrischen Aktormoduls eine Verringerung der Druckschwankungen im System erzielt und somit ein optimiertes Einspritzkennfeld erreicht werden.

In vorteilhafter Weise ist die polymere Schicht mit einer Wicklung von 360° gewickelt. Dabei ist es ferner vorteilhaft, dass die gewickelte polymere Schicht eine Naht aufweist, wobei die Naht über Organik verbunden ist. Ferner kann die Organik auch die Schichten des Aktorschlauches umgeben, beispielsweise indem das gesamte Schichtsystem mittels Organik in Sprühprozessen oder dgl. überzogen wird. Dadurch kann die Dichtwirkung der Schichten des Aktorschlauches weiter verbessert werden.

In vorteilhafter Weise ist die metallische Schicht in einer Umfangsrichtung überlappend gewickelt. Dies hat den Vorteil, dass eine hohe Dichtwirkung erzielt ist. Ferner kann durch das Überlappen der metallischen Schicht die darunter liegende polymere Schicht im Nahtbereich überdeckt und ausreichend geschützt werden, wobei der Permeations- oder Kriechweg für Brennstoffe oder andere Medien verlängert ist.

In vorteilhafter Weise sind die Schichten des Aktorschlauches als laminierte Schichten ausgebildet, wobei eine dadurch erzeugte laminierte Folie Grundlage für die Herstellung des Aktorschlauches sein kann.

Ferner ist es vorteilhaft, dass die Schichten des Aktorschlauches flächig miteinander verbunden sind, so dass eine feste Verbindung der Schichten untereinander besteht. Die Schichten des Aktorschlauches können in einem Laminierprozess entsprechend auf Maß gebracht und beispielsweise in einem Blasprozess mithilfe von zweigeteilten Werkzeugen als Schlauch geformt oder mithilfe von Dornen als Schlauch geformt werden.

In vorteilhafter Weise ist ein zwischen dem Aktorkörper und dem Aktorschlauch ausgebildeter Zwischenraum zumindest teilweise mit einem Füllmittel aufgefüllt. Dabei ist es vorteilhaft, dass ein solches Füllmittel aus zumindest einem Kunststoff, insbesondere einem Polymer, gebildet ist. Speziell kann der Zwischenraum mit einem als Vergussmasse ausgestalteten Füllmittel ausgegossen sein. In vorteilhafter Weise sind die Schichten des Aktorschlauches als laminierte Folien ausgestaltet, die in einem thermischen Prozess hergestellt sind.

### Kurze Beschreibung der Zeichnungen

Bevorzugte Ausführungsbeispiele der Erfindung sind in der nachfolgenden Beschreibung anhand der beigefügten Zeichnungen, in denen sich entsprechende Elemente mit übereinstimmenden Bezugszeichen versehen sind, näher erläutert. Es zeigt:
- Fig. 1: ein Brennstoffeinspritzventil mit einem piezoelektrischen Aktormodul in einer schematischen Schnittdarstellung entsprechend einem ersten Ausführungsbeispiel der Erfindung und
- Fig. 2: einen Schnitt durch das in Fig. 1 gezeigte piezoelektrische Aktormodul entlang der mit II bezeichneten Schnittlinie.

### Ausführungsformen der Erfindung

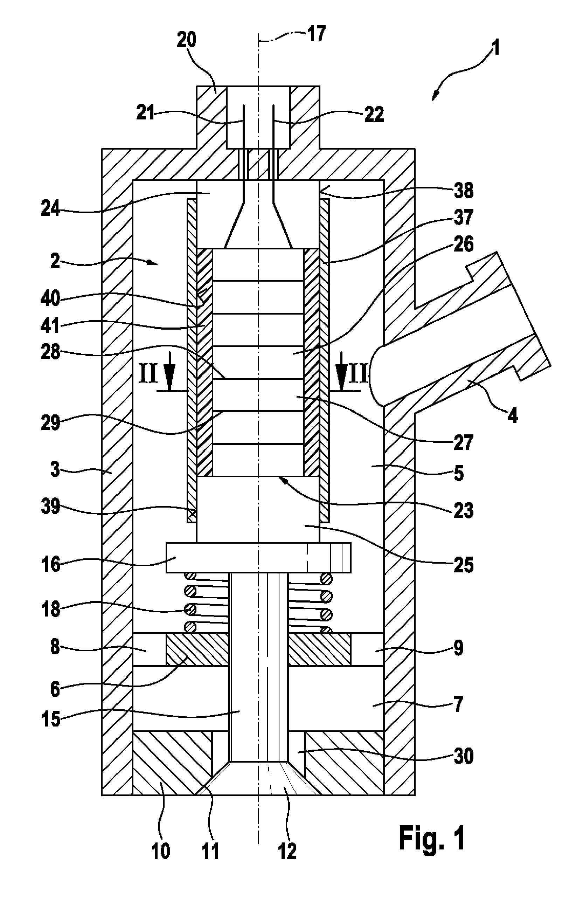

Fig. 1 zeigt ein Brennstoffeinspritzventil 1 mit einem piezoelektrischen Aktormodul 2 entsprechend einem ersten Ausführungsbeispiel der Erfindung. Das Brennstoffeinspritzventil 1 kann insbesondere als Injektor für Brennstoffeinspritzanlagen von luftverdichtenden, selbstzündenden Brennkraftmaschinen dienen. Ein bevorzugter Einsatz des Brennstoffeinspritzventils 1 besteht für eine Brennstoffeinspritzanlage mit einem Common-Rail, das Dieselbrennstoff unter hohem Druck zu mehreren Brennstoffeinspritzventilen 1 führt. Das erfindungsgemäße piezoelektrische Aktormodul 2 eignet sich besonders für solch ein Brennstoffeinspritzventil 1 und auch für eine inverse Ansteuerung des piezoelektrischen Aktormoduls 2. Das erfindungsgemäße Brennstoffeinspritzventil 1 und das erfindungsgemäße piezoelektrische Aktormodul 2 eignen sich jedoch auch für andere Anwendungsfälle.

Das Brennstoffeinspritzventil 1 weist ein Ventilgehäuse 3 und einen mit dem Ventilgehäuse 3 verbundenen Brennstoffeinlassstutzen 4 auf. An den Brennstoffeinlassstutzen 4 ist eine Brennstoffleitung anschließbar, um das Brennstoffeinspritzventil 1 über ein Common-Rail oder direkt mit einer Hochdruckpumpe zu verbinden. Über den Brennstoffeinlassstutzen 4 kann dann Brennstoff in einen im Inneren des Ventilgehäuses 3 vorgesehenen Aktorraum 5 eingeleitet werden, so dass sich im Betrieb des Brennstoffeinspritzventils 1 Brennstoff in dem Aktorraum 5, in dem auch das piezoelektrische Aktormodul 2 vorgesehen ist, befindet. Der Aktorraum 5 ist durch ein Gehäuseteil 6 von einem ebenfalls im Inneren des Ventilgehäuses 3 vorgesehenen Brennstoffraum 7 getrennt. In dem Gehäuseteil 6 sind dabei Durchlassöffnungen 8, 9 ausgestaltet, um den über den Brennstoffeinlassstutzen 4 in den Aktorraum 5 geführten Brennstoff in den Brennstoffraum 7 zu leiten.

Das Ventilgehäuse 3 ist mit einem Ventilsitzkörper 10 verbunden, an dem eine Ventilsitzfläche 11 ausgebildet ist. Die Ventilsitzfläche 11 wirkt mit einem Ventilschließkörper 12 zu einem Dichtsitz zusammen. Dabei ist der Ventilschließkörper 12 einstückig mit einer Ventilnadel 15 ausgebildet, über die der Ventilschließkörper 12 mit einer im Aktorraum 5 vorgesehenen Druckplatte 16 verbunden ist. Dabei ist die Ventilnadel 15 durch das Gehäuseteil 6 entlang einer Achse 17 des Brennstoffeinspritzventils 1 geführt. Ein Federelement 18, das einerseits an dem Gehäuseteil 6 und andererseits an der Druckplatte 16 anliegt, beaufschlagt den piezoelektrischen Aktor 2 mit einer Vorspannkraft, wobei durch die Beaufschlagung außerdem die Ventilnadel 15 mittels der Druckplatte 16 betätigt wird, so dass der zwischen dem Ventilschließkörper 12 und der Ventilsitzfläche 11 gebildete Dichtsitz geschlossen ist.

Außerdem weist das Ventilgehäuse 3 ein Anschlusselement 20 auf, um das Anschließen einer elektrischen Zuleitung an das Brennstoffeinspritzventil 1 zu ermöglichen. Die elektrische Zuleitung kann dabei mittels eines Steckers an elektrische Leitungen 21, 22 angeschlossen werden. Die elektrischen Leitungen 21, 22 sind durch das Gehäuse 3 und einen an einen Aktorkörper 23 des Aktormoduls 2 angefügten Aktorfuß 24 an den Aktorkörper 23 geführt. An den Aktorkörper 23 des piezoelektrischen Aktormoduls 2 ist ferner ein Aktorkopf 25 angefügt, über den der Aktorkörper 23 entgegen der Kraft des Federelements 18 auf die Druckplatte 16 einwirkt. Das piezoelektrische Aktormodul 2 weist in dem dargestellten Ausführungsbeispiel den Aktorkörper 23, den Aktorfuß 24 und den Aktorkopf 25 auf. Der Aktorfuß 24 und der Aktorkopf stellen jeweils ein an den Aktorkörper 23 angefügtes Übergangsstück dar.

Der Aktorkörper 23 des piezoelektrischen Aktormoduls 2 weist eine Vielzahl von keramischen Schichten 26, 27 und eine Vielzahl von zwischen den keramischen Schichten 26, 27 angeordneten Elektrodenschichten 28, 29 auf. Dabei sind in der Fig. 1 zur Vereinfachung der Darstellung nur die keramischen Schichten 26, 27 sowie die Elektrodenschichten 28, 29 gekennzeichnet. Die Elektrodenschichten 28, 29 sind abwechselnd mit der elektrischen Leitung 21 und der elektrischen Leitung 22 verbunden, so dass alternierend positive und negative Elektroden zwischen den keramischen Schichten 26, 27 vorgesehen sind.

Über die elektrischen Leitungen 21, 22 kann der Aktorkörper 23 geladen werden, wobei sich dieser in Richtung der Achse 17 ausdehnt, so dass der zwischen dem Ventilschließkörper 12 und der Ventilsitzfläche 11 ausgebildete Dichtsitz geöffnet wird. Dadurch kommt es zum Abspritzen von Brennstoff aus dem Brennstoffraum 7 über einen Ringspalt 30 und den geöffneten Dichtsitz. Beim Entladen des Aktorkörpers 23 zieht sich dieser wieder zusammen, so dass der zwischen dem Ventilschließkörper 12 und der Ventilsitzfläche 11 ausgebildete Dichtsitz wieder geschlossen ist.

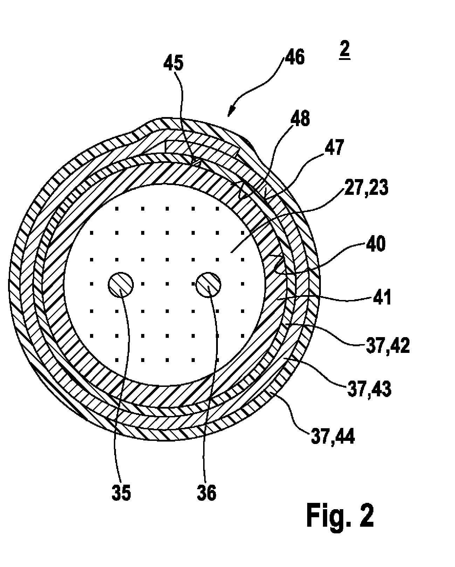

Die Verbindung der elektrischen Leitungen 21, 22 mit den Elektrodenschichten 28, 29 kann durch innenliegende Elektrodenanbindungen 35, 36 erfolgen, wie es in Fig. 2 veranschaulicht ist. Es können allerdings auch außenliegende Elektrodenanbindungen vorgesehen sein. Der Aktorkörper 23 ist zwischen dem Aktorkopf 25 und dem Aktorfuß 24 angeordnet.

Das piezoelektrische Aktormodul 2 weist einen Aktorschlauch 37 auf, der den Aktorkörper 23 umgibt. Ferner umgibt der Aktorschlauch 37 den Aktorfuß 24 sowie den Aktorkopf 25 jeweils zumindest abschnittsweise. Der Aktorschlauch 37 ist im Bereich einer Außenfläche 38 mit dem Aktorfuß 24 und im Bereich einer Außenfläche 39 mit dem Aktorkopf 25 verbunden. Zwischen dem Aktorkörper 23 und dem Aktorschlauch 37 ist ein Zwischenraum 40 ausgebildet, der mit einem Füllmittel 41 aufgefüllt ist. Insbesondere kann das Füllmittel 41 aus einer Vergussmasse gebildet sein, so dass der Zwischenraum 40 ausgegossen ist. Das Füllmittel 41 kann aus einem oder mehreren Kunststoffen, insbesondere einem Polymer, bestehen.

Im Betrieb des Brennstoffeinspritzventils 1 befindet sich im Aktorraum 5 unter hohem Druck stehender Brennstoff. Dabei besteht die Gefahr, dass der Brennstoff oder zumindest ein Bestandteil des Brennstoffes die Funktionsfähigkeit des piezoelektrischen Aktormoduls 2 beeinträchtigt. Speziell besteht die Gefahr, dass der Brennstoff oder ein Bestandteil des Brennstoffes in den Zwischenraum 40 eindringt und von dort weiter zu dem Aktorkörper 23 kriecht. Beispielsweise besteht die Gefahr, dass im Dieselbrennstoff enthaltenes Wasser zu dem Aktorkörper 23 gelangt und einen Kurzschluss zwischen den Elektrodenschichten 28, 29 verursacht. Ferner besteht die Gefahr einer chemischen oder physikalischen Beschädigung des Materials des Aktorkörpers 23.

Um eine Beeinträchtigung des piezoelektrischen Aktormoduls 2 zu verhindern, ist der Aktorschlauch 37 mehrschichtig aufgebaut, wie es anhand der Fig. 2 in weiterem Detail beschrieben ist. Ferner wird durch das Füllmittel 41 im Zwischenraum 40 die Abdichtung weiter verbessert bzw. der Aktorschlauch 37 unterstützt. Speziell gewährleistet das Füllmittel 41, das den Zwischenraum 40 ausfüllt, dass die durch den Druck des Brennstoffes im Aktorraum 5 auf den Aktorschlauch 37 einwirkenden Kräfte aufgenommen werden, so dass eine mechanische Beschädigung des Aktorschlauches 37 verhindert ist. Speziell besteht der Vorteil, dass der Aktorschlauch 37 relativ dünnwandig ausgestaltet sein kann, so dass der Platzbedarf des piezoelektrischen Aktormoduls 2 im Aktorraum 5 des Brennstoffeinspritzventils 1 optimiert ist.

Fig. 2 zeigt einen Schnitt durch das in der Fig. 1 dargestellte piezoelektrische Aktormodul 2 des Brennstoffeinspritzventils 1 entlang der mit II bezeichneten Schnittlinie. Der Schnitt verläuft dabei durch die keramische Schicht 27, wobei in der Fig. 2 die innenliegenden Elektrodenanbindungen 35, 36 veranschaulicht sind. Ferner ist der mehrschichtige Aktorschlauch 37 dargestellt, der in diesem Ausführungsbeispiel aus zwei Schichten 42, 43 und einer die Schichten 42, 43 umgebenden Organik 44 ausgestaltet ist. Zwischen dem Aktorschlauch 37 und dem Aktorkörper 23 füllt das Füllmittel 41 den Zwischenraum 40 vollständig auf, so dass eine Abstützung des Aktorschlauches 37 über das Füllmittel 41 an dem Aktorkörper 23 in Bezug auf den Druck des umgebenden Mediums ermöglicht ist.

In diesem Ausführungsbeispiel ist die innenliegende Schicht 42 des Aktorschlauches 37 als polymere Schicht 42 ausgebildet. Ferner ist die Schicht 43, die die polymere Schicht 42 umgibt, als metallische Schicht 43 ausgebildet. Das aus den Schichten 42, 43 ausgebildete Schichtsystem ist mit der Organik 44 überzogen, was beispielsweise durch Sprühprozesse erreicht werden kann.

Die polymere Schicht 42 ist genau einmal, d.h. im Wesentlichen um 360° gewickelt. Zum Schließen der polymeren Schicht 42 nach der Wicklung ist eine Naht 45 vorgesehen, die durch eine Organik verbunden sein kann.

Die metallische Schicht 43 ist überlappend, d.h. mehr als 360°, gewickelt, wobei sich ein Überlappungsbereich 46 ergibt. Dabei wird durch den Überlappungsbereich 46 die Naht 45 überdeckt und gegenüber der Umgebung geschützt. Ferner ist durch den Überlappungsbereich 46 ein Permeations- oder Kriechweg für gegebenenfalls eindringende Medien, insbesondere Brennstoffe oder Bestandteile von Brennstoffen, verlängert.

Die polymere Schicht 42 ist fest mit der metallischen Schicht 43 verbunden. Dabei ist die polymere Schicht 42 an ihrer gesamten außenliegenden Oberfläche 47 mit einer innenliegenden Oberfläche 48 der metallischen Schicht 43 verbunden. Die Schichten 42, 43 können beispielsweise im Laminierprozess entsprechend auf Maß gebracht und in einem Blasprozess mithilfe von zweigeteilten Werkzeugen als Schlauch geformt oder mithilfe von Dornen als Schlauch ausgeformt werden. Die Verbindung der Schichten 42, 43 kann beispielsweise durch gezielte Einwirkung von Druck und Temperatur erfolgen. Durch den Laminataufbau des Aktorschlauches 37 können relativ geringe Wandstärken bei hoher Festigkeit und Dichtwirkung erzielt werden.

Die Erfindung ist nicht auf die beschriebenen Ausführungsbeispiele beschränkt.

## Patentansprüche

1. Piezoelektrisches Aktormodul (2), insbesondere Aktormodul für Brennstoffeinspritzventile, mit einem Aktorkörper (23), der eine Vielzahl von keramischen Schichten (26, 27) und eine Vielzahl von zwischen den keramischen Schichten (26, 27) angeordneten Elektrodenschichten (28, 29) aufweist,
**dadurch gekennzeichnet,**
**dass** ein Aktorschlauch (37) vorgesehen ist, der den Aktorkörper (23) umgibt, und dass der Aktorschlauch (37) zumindest eine gewickelte metallische Schicht (43) und zumindest eine gewickelte polymere Schicht (42) aufweist, die miteinander verbunden sind.

2. Piezoelektrisches Aktormodul nach Anspruch 1,
**dadurch gekennzeichnet,**
**dass** die metallische Schicht (43) überlappend gewickelt ist.

3. Piezoelektrisches Aktormodul nach Anspruch 1 oder 2,
**dadurch gekennzeichnet,**
**dass** die polymere Schicht (42) zumindest näherungsweise mit einer Wicklung von 360° gewickelt ist.

4. Piezoelektrisches Aktormodul nach Anspruch 3,
**dadurch gekennzeichnet,**
**dass** die gewickelte polymere Schicht (42) eine Naht (45) aufweist.

5. Piezoelektrisches Aktormodul nach Anspruch 4,
**dadurch gekennzeichnet,**
**dass** die Naht (45) über eine Organik verbunden ist.

6. Piezoelektrisches Aktormodul nach Anspruch 4 oder 5,
**dadurch gekennzeichnet,**
**dass** die gewickelte metallische Schicht (43) die Naht (45) der gewickelten polymeren Schicht (42) überdeckt.

7. Piezoelektrisches Aktormodul nach einem der Ansprüche 1 bis 6,
**dadurch gekennzeichnet,**
**dass** zumindest eine der Schichten (42, 43) des Aktorschlauches (37) als laminierte Schicht ausgebildet ist.

8. Piezoelektrisches Aktormodul nach einem der Ansprüche 1 bis 7,
**dadurch gekennzeichnet,**
**dass** die Schichten (42, 43) des Aktorschlauches (37) flächig miteinander verbunden sind.

9. Piezoelektrisches Aktormodul nach einem der Ansprüche 1 bis 8,
**dadurch gekennzeichnet,**
**dass** die Schichten (42, 43) des Aktorschlauches (37) mit zumindest einer Organik (44) überzogen sind.

10. Brennstoffeinspritzventil (1), insbesondere Injektor für Brennstoffeinspritzanlagen von luftverdichtenden, selbstzündenden Brennkraftmaschinen, mit einem piezoelektrischen Aktormodul (2) nach einem der Ansprüche 1 bis 9 und einem von dem Aktormodul (2) zumindest mittelbar betätigbaren Ventilschließkörper (12), der mit einer Ventilsitzfläche (11) zu einem Dichtsitz zusammenwirkt, wobei das Aktormodul (2) in einem Aktorraum (5) angeordnet ist, in dem sich im Betrieb unter hohem Druck stehender Brennstoff befindet.
